**Europäisches Patentamt**

**European Patent Office**

**Office européen des brevets**

(11) Numéro de publication: **0 300 880**
**A1**

(12) **DEMANDE DE BREVET EUROPEEN**

(21) Numéro de dépôt: **88401821.9**

(22) Date de dépôt: **12.07.88**

(51) Int. Cl.⁴: **H 03 H 21/00**

(30) Priorité: **16.07.87 FR 8710018**

(43) Date de publication de la demande:
**25.01.89 Bulletin 89/04**

(84) Etats contractants désignés: **DE GB IT NL**

(71) Demandeur: **CENTRE NATIONAL DE LA RECHERCHE SCIENTIFIQUE**
**15, quai Anatole France**
**F-75007 Paris (FR)**

(72) Inventeur: **Macchi, Odile**
**4 Rue du Général Duchesse**
**F-91400 Orsay (FR)**

**Jaidane, Meriem Lab. des signaux et systèmes-L2S**
**Ecole supérieure d'électricité Plateau du Moulon**
**F-91190 Gif sur Yvette (FR)**

(74) Mandataire: **Fort, Jacques et al**
**CABINET PLASSERAUD 84, rue d'Amsterdam**
**F-75009 Paris (FR)**

(54) **Prédicteur adaptatif.**

(57) Le prédictur comporte un filtre linéaire fournissant, en réponse à une erreur de prédiction e(n), un signal s(n) :
$$s(n) = A^T S(n) + B^T E(n) + e(n)$$
où :
$A^T$ et $B^T$ sont les vecteurs des coefficients du filtre,
$S(n)$ est le vecteur des échantillons passés de s(n), et
$E(n)$ est le vecteur des erreurs passées e(n). Des moyens (12. 14, 18, 20) élaborant les vecteurs $A^T$ et $B^T$ par un algorithme d'adaptation faisant intervenir, dans les termes d'incrémentation :

$$e(n) - \frac{\lambda_A}{1+\lambda_A} s(n) \qquad et$$

$$e(n) - \frac{\lambda_B}{1+\lambda_B} s(n)$$

où $\lambda_A$ et $\lambda_B$ sont des valeurs fixes comprises entre 0,05 et 0,3 et e(n) est l'erreur de prédiction, égale à la différence entre le signal s(n) et sa valeur $\hat{s}(n)$ prédite.

FIG.2.

**EP 0 300 880 A1**

## Description

### Prédicteur adaptatif.

La présente invention concerne les prédicteurs adaptatifs de modélisation de signaux, utilisables notamment pour la compression ou l'identification de signaux.

L'invention trouve une application particulièrement importante dans la compression des signaux en vue de leur mémorisation ou de leur transmission. De tels prédicteurs adaptatifs sont par exemple prévus dans les installations de transmission utilisant le codage MICDA dit aussi ADPCM.

L'invention concerne plus particulièrement le prédicteurs dits auto-régressifs à moyenne ajustée, en abréviation ARMA, constituant un filtre linéaire qui fournit, en réponse à un signal s(n) de puissance généralement très variable dans le temps, une erreur de prédiction e(n) selon l'équation :

$$e(n) = s(n) - \sum_{i=1}^{p} a^i s(n-i) - \sum_{j=1}^{q} b^j e(n-j) \qquad (1)$$

Le signal s(n) est en géneral fortement non stationnaire et les coefficients a et b sont en conséquence des fonctions du temps.

Le premier terme en $\Sigma$ de l'équation (1) correspond à un prédicteur purement auto-régressif ayant le caractère d'un filtre transverse, souvent suffisant comme dans le cas d'un signal aléatoire à bande étroite qui est assimilable à la réponse d'un filtre autorégressif linéaire à une excitation aléatoire blanche. Par contre, dans le cas de beaucoup de signaux de nature différente, comme pour des signaux de parole, on se prive d'un gain notable de prédiction en omettant la partie MA. En conséquence, on sera souvent amené à utiliser un prédicteur ARMA répondant à la formule (1).

Mais l'utilisation d'un prédicteur ARMA se heurte, dans le cas de signaux à bande étroite ou, plus généralement, quand le spectre présente des flancs de montée raide, à des problèmes de stabilité.

Pour mieux faire apparaître ces problèmes, il peut être utile de rappeler tout d'abord quelques données concernant la prédiction adaptative ARMA.

Pour simplifier les équations, on utilisera dans la suite une notation vectorielle :

$A^T = (a^1, a^2, ..., a^p)^T$ ; $B^T = (b^1, b^2, ..., b^q)^T$ (2)

$S(n) = (s(n-1), ..., s(n-p))^T$ ; $E(n) = (e(n-1), ..., e(n-q))^T$ (3)

où les vecteurs S(n) et E(n) correspondent aux échantillons passés des signaux considérés. Le modèle de prédicteur (1) s'écrit alors :

$s(n) = A^T S(n) + B^T E(n) + e(n)$ (4)

On obtient une compression du signal en conservant comme informations les vecteurs A et B, éventuellement numérisés, et l'erreur e(n), sous une forme qui dépend de l'application, et en oubliant le signal s(n) originel. Cette méthode de compression est notamment appliquée dans les systèmes de codage numérique à débit réduit du signal téléphonique, tel que le codage MICDA.

Lorsque le signal s(n) est non stationnaire, les vecteurs A et B et la puissance de l'erreur e(n) sont des fonctions du temps n.

La prédiction adaptative doit identifier en permanence, au cours du temps, les grandeurs A(n), B(n), e(n) sur la base du seul signal s(n).

La quantité

$\hat{s}(n) = A(n)^T S(n) + B(n)^T E(n)$ (6)

représente une prédiction du signal basée sur des observations du passé et

$e(n) = s(n) - \hat{s}(n)$ (7)

est l'erreur de prédiction.

Pour identifier les paramètres A et B, des algorithmes adaptatifs ont été proposés dans la littérature. Ils peuvent s'écrire sous la forme :

$A(n+1) = A(n) + \alpha\ f[e(n); e(n-1); ...; s(n), s(n-1), ...]$ (8)

$B(n+1) = B(n) + \beta\ g(e(n); e(n-1); ...; s(n), s(n)-1), ...]$ (9)

Ces algorithmes visent à minimiser une moyenne quadratique de e(n).

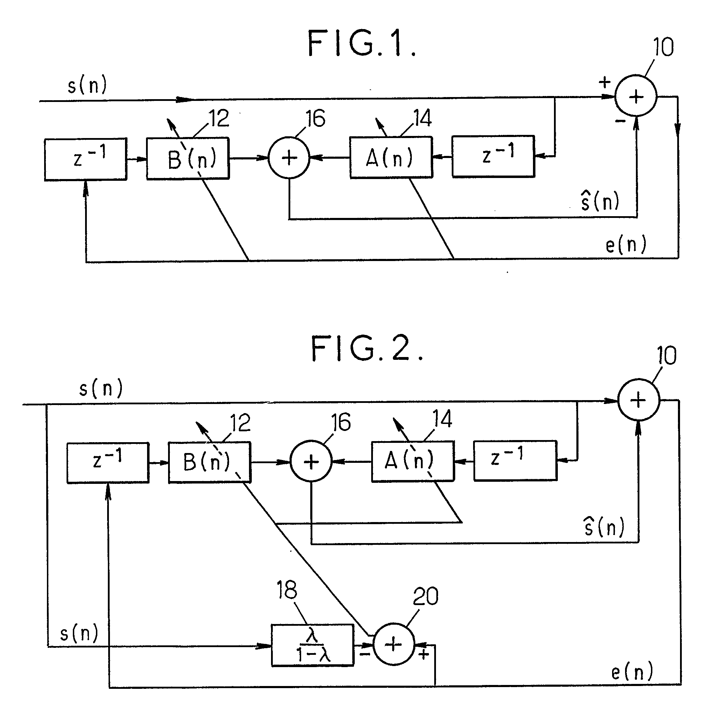

La figure 1 donne une représentation très schématique d'une constitution possible d'un prédicteur ARMA. Le signal modélisé s(n) est appliqué à un additionneur 10 dont l'entrée soustractive reçoit l'estimation s(n). La sortie de l'additionneur, représentant l'erreur de prédiction $e_n$, est appliquée à des circuits adaptatifs 12 et 14 d'élaboration des vecteurs B(n) et A(n) qui peuvent avoir l'une quelconque des constitutions bien connues. Les signaux s(n) et e(n) sont appliqués, après retard $z^{-1}$, respectivement aux filtres 14 et 12 dont les vecteurs de coefficients sont A(n) et B(n). Les sorties des deux filtres sont appliquées sur les deux entrées d'un additionneur 16 qui fournit $\hat{s}(n)$.

Lorsque les paramètres du prédicteur sont fixes, le prédicteur (1) est un filtre linéaire récursif dont la sortie e(n) associée à l'entrée s(n) peut s'écrire à l'aide des polynomes

$$A(z) = \sum_{i=1}^{p} a^i z^{-i} \quad ; \quad B(z) = \sum_{j=1}^{q} b^j z^{-j} \qquad (10)$$

selon

$$e(n) = H(z).s(n) \quad avec \quad H(z) = \frac{1-A(z)}{1+B(z)} \qquad (11)$$

Le problème de stabilité dans la mise en oeuvre d'un tel prédicteur adaptatif fait intervenir la fonction H(z) et aussi H⁻¹(z) :

a) la stabilité de la fonction H(z) est liée à la forme de l'algorithme adaptatif (9). Les zéros du polynome (1+B(z)) doivent demeurer à l'intérieur du cercle unité. Faute d'obtenir cette propriété, l'erreur de prédiction e(n) donnée par (11) risque de diverger ;

b) la stabilité de la fonction de transfert inverse H⁻¹(z) est liée uniquement à la position des zéros du polynome (1-A(z)) qui doivent demeurer à l'intérieur du cercle unité. Faute d'obtenir cette propriété, la restitution du signal s(n) à partir des paramètres A, B et de l'excitation e(n) risque de diverger, dès que cette dernière comporte un peu de bruit, ce qui est le cas général.

Ces deux critères sont d'autant plus difficiles à remplir que le signal s(n) est à bande étroite par rapport à la largeur du canal et que son spectre présente des flancs de montée raide. Une solution permettant d'écarter le problème (a) consiste à adopter B=0 mais, comme on l'a vu plus haut, cette solution n'est pas acceptable dans le cas d'un signal de parole car elle se traduit par une perte de gain de prédiction appréciable.

Pour remplir les critères il est possible de prévoir, dans le prédicteur, des moyens de calcul et de test des zéros de 1-A$_n$(z) et de 1+B$_n$ à chaque itération d'ordre n. Mais le calcul est très lourd dès que les ordres p et q des parties auto-régressive et moyenne ajustée dépassent 2, ce qui est le cas sauf lorsqu'on se contente d'une prédiction rudimentaire.

Une autre solution encore consiste à réaliser le prédicteur sous forme d'une cascade de cellules ARMA d'ordre 2,2, dont la stabilité peut facilement être testée par des circuits simples, à l'aide du triangle de stabilité.

Mais en contrepartie, ce montage en cascade rend difficile la minimisation quadratique de e(n) de manière algorithmique.

D'autres solutions encore existent : toutes se traduisent soit par une complexité généralement inacceptable des calculs, soit par un effet défavorable sur la valeur résiduelle de e(n) ou le gain de prédiction.

La présente invention vise à fournir un prédicteur répondant mieux que ceux antérieurement connus aux exigences de la pratique permettant tout à la fois d'arriver à la stabilité de H(z) et de H⁻¹(z) et d'éviter une effet défavorable sur le gain de prédiction et d'éviter un accroissement appréciable de la complexité des calculs et des circuits.

Ce résultat a été atteint à partir d'une analyse mathématique des algorithmes de prédiction et des effets recherchés et de la constatation qu'il est possible, sans pour autant affecter de façon défavorable les résultats de prédiction, d'adopter, au lieu d'un critère de prédiction pure, un critère résultant d'un compromis entre la recherche d'un gain de prédiction maximale et la nécessité de rendre stable H(z) et H⁻¹(z).

L'analyse sera faite à titre d'exemple pour le cas fréquent où les algorithmes de prédiction adaptative (8) et (9) destinés à l'élaboration des paramètres A et B sont destinés à minimiser par itération la quantité :

$J_c(A,B) = E(e^2(n)) \quad (12)$

pour un signal s(n) donné.

On peut citer l'algorithme classique dit LMS récursif qui s'écrit :

$A(n+1) = A(n) + \alpha e(n)S(n)$, avec $\alpha > 0$ (13)

$B(n+1) = B(n) + \beta e(n)E(n)$, avec $\beta > 0$ (14)

Lors de la convergence, les incréments ont une moyenne nulle. L'erreur de sortie e(n) est donc décorrélée des erreurs passées e(n-j) et des entrées passées s(n-i).

Mais lorsque s(n) a un spectre "raide" (ce qui est le cas des tonalités ou des sons voisés dans la parole) les paramètres A(n) et B(n) deviennent très voisins de la frontière de stabilité : les fluctuations dues à l'algorithme déterminent des instabilités pour la fonction de transfert H(z) et la fonction de transfert inverse H⁻¹(z).

Il faut remarquer que, dans le cas des signaux à bande étroite, on démontre aussi que le paramètre B(n) traverse inexorablement et de manière quasi-périodique, la frontière de stabilité : la fonction de transfert directe H(z) est donc elle aussi périodiquement instable.

Pour la stabiliser, on introduit conformément à l'invention, une fonction de coût Js similaire à Jc et représentant la puissance du signal prédit:

$J\hat{s}(A,B) = E(s^2(n))$ (15)

En minimisant la fonction d'espérance mathématique $J\hat{s}$ on stabilise le prédicteur pour une entrée s(n) donnée.

Et, puisque le signal restitué par le prédicteur inverse, pour une entrée e(n) donnée, ne diffère de $\hat{s}(n)$ que par e(n), en minimisant Js on stabilise aussi le prédicteur inverse.

Cette constatation conduit à abandonner la recherche d'une puissance Jc minimum en faveur de la recherche d'une valeur minimum du coût $J_N$ défini par :

$J_N(A,B) = Jc(A,B) + \lambda Js(A,B)$, avec $\lambda > 0$ (16)

On réalise ainsi un compromis entre la maximisation du gain de prédiction (qui exigerait la recherche d'un minimum de Jc) et la stabilité des fonctions $H^{-1}(z)$ et $H(z)$ (qui impliquerait un minimum de Js).

En conséquence, l'invention propose un prédicteur auto-régressif à moyenne ajustée de modélisation de signaux, comportant un filtre linéaire fournissant un signal s(n), en réponse à une erreur de prédiction e(n) :

$s(n) = A^T S(n) + B^T E(n) + e(n)$ (4)

où :

$A^T$ et $B^T$ sont les vecteurs des coefficients du filtre,

S(n) est le vecteur des échantillons passés de s(n), et

E(n) est le vecteur des erreurs passées e(n),

caractérisé par des moyens pour élaborer les vecteurs $A^T$ et $B^T$ par un algorithme d'adaptation faisant intervenir, dans le terme d'incrémentation :

$$e(n) - \frac{\lambda}{1+\lambda} s(n)$$

où $\lambda$ est une valeur fixe comprise entre 0,05 et 0,3 et e(n) est l'erreur de prédiction, égale à la différence entre le signal s(n) et sa valeur $\hat{s}(n)$ prédite.

On choisira toujours une valeur de $\lambda$ nettement inférieure à 1, toute valeur approchant de 1 et surtout le dépassant se traduisant par une dégradation des performances du prédicteur, car il y a pratiquement suppression de la prédiction. On cherchera à s'approcher le plus possible de la valeur minimum de $\lambda$ pour laquelle la stabilité est assurée pour le type de signal à traiter le plus défavorable. $\lambda$ sera toujours pratiquement supérieur à 0,05 et inférieur à 0,25.

Pour des prédicteurs purement auto-régressifs, ayant un nombre de coefficients courant, c'est-à-dire compris entre deux et dix, typiquement six, on peut estimer qu'une valeur de $\lambda_A$ (c'est-à-dire intervenant dans A) proche de 0,1 constitue un compromis satisfaisant. Une détermination plus précise de $\lambda_A$ est possible à l'aide d'abaques, le coefficient $\lambda_A$ diminuant lorsque le rapport entre la largeur de bande et la fréquence d'échantillonnage augmente. Au delà d'une largeur de bande $W = 1/16$ de la fréquence d'échantillonnage on peut fixer $\lambda_A = 0$.

Pour des prédicteurs purement MA, ayant un nombre de coefficients assez élevé, supérieur ou égal à 6, la valeur de $\lambda_B$ (intervenant dans B) doit être choisie plus grande que dans le cas AR (typiquement 0,3). En effet, ces prédicteurs modélisent mal les signaux à bande étroite. Dans la pratique cependant, ce n'est pas un inconvénient car on n'utilise pas de prédicteurs purement MA. Pour des prédicteurs ARMA dont la partie AR a au moins deux coefficients, on conservera avantageusement la valeur $\lambda_A$ précédemment proposée pour stabiliser la partie AR et on réduira $\lambda_B$ à la même valeur que $\lambda_A$, typiquement $\lambda_A = \lambda_B - 0,1$.

L'invention propose donc de substituer, dans le cas où on utilise l'algorithme LMS récursif, les formule (13 bis) ou (14 bis) ci-après aux formules (13) et (14) :

$$A(n+1) = A(n) + \alpha[e(n) - \frac{\lambda_A}{1+\lambda_A} s(n)]S(n) \qquad (13 \text{ bis})$$

$$B(n+1) = B(n) + \beta[e(n) - \frac{\lambda_B}{1+\lambda_B} s(n)]E(n) \qquad (14 \text{ bis})$$

Naturellement, on pourrait de même adopter certains autres algorithmes adaptatifs mettant en oeuvre une fonction autre que le gradient (par exemple l'algorithme du signe). Dans le cas de l'algorithme du signe, on aurait par exemple :

$$A(n+1) = A(n) + signe[e(n) - \frac{\lambda_A}{1+\lambda_A} s(n)]S(n) \qquad (13 \text{ ter})$$

$$B(n+1) = B(n) + signe[e(n) - \frac{\lambda_B}{1+\lambda_B} s(n)]E(n) \qquad (14 \text{ ter})$$

L'invention sera mieux comprise à la lecture de la description qui suit d'un mode particulier de réalisation donné à titre d'exemple non limitatif. La description se réfère aux dessins qui l'accompagnent, dans lesquels :
- la figure 1, déjà mentionnée, est un schéma de principe d'un prédicteur adaptatif de type connu ;
- la figure 2, similaire à la figure 1, montre une constitution possible d'un prédicteur suivant l'invention.

Le prédicteur montré schématiquement en figure 2 ne se différencie de celui de la figure 1 que par l'adjonction des éléments permettant de passer des algorithmes (13) et (14) aux algorithmes (13 bis) et (14bis) respectivement. Les éléments identiques à ceux de la figure 1 sont désignés par le même numéro de référence. Le dispositif comporte de plus un soustracteur 20 qui reçoit le signal e(n) sur son entrée additive et qui reçoit, sur son entrée soustractive, le signal s(n) amplifié dans le rapport $\lambda/1+\lambda$ par un circuit 18.

On voit que le circuit supplémentaire nécessaire est de constitution extrêmement simple et que le coût du prédicteur dans son ensemble n'est pratiquement pas modifié.

Pour déterminer l'effet obtenu par la mise en oeuvre de l'invention, on considèrera successivement l'accroissement de stabilité obtenu d'abord par le passage de (13) à (13 bis) puis de (14) à (14 bis).

Si on appelle respectivement $A^c$ et $A^N$ les points d'équilibre du système classique (13) et du système stabilisé (13 bis), on montre que :

$$A^N = \frac{A^C}{1 + \lambda}$$

On démontre théoriquement que, pour $\lambda_A$ assez grand ($\lambda_A$ supérieur à une valeur $\lambda_0$ indépendante de A, donc du type de signal s(n)), l'homothétie correspondante $(1+\lambda_A)^{-1}$ ramène la prédiction à l'intérieur du domaine de stabilité si $A^c$ était à la limite de ce domaine de stabilité.

Avec la même convention et sous les hypothèses que l'ordre q est assez élevé et que $\lambda_B$ est très inférieur à un, on démontre encore que :

$$B^N = \frac{B^C}{1 + \lambda_B}$$

La conclusion théorique est identique : la contraction $(1+\lambda_B)^{-1}$ a tendance à ramener le prédicteur à l'intérieur du domaine de stabilité si $B^c$ était à la limite de ce domaine.

Dans les adaptations (13 bis) et (14 bis), les évolutions des parties AR et MA sont couplées du fait du e(n) qui intervient dans les deux incréments. Ceci permet une meilleure optimisation du prédicteur que celle qui consiste à optimiser séparément les parties AR et MA. Le gain de prédiction s'en trouve amélioré et la valeur $\lambda_B$ peut être réduite.

**Revendications**

1. Prédicteur auto-régressif de modélisation de signaux, comportant un filtre linéaire fournissant, en réponse à une erreur de prédiction e(n), un signal s(n) :
$s(n) = A^T S(n) + B^T E(n) + e(n)$
où :

$A^T$ et $B^T$ sont les vecteurs des coefficients du filtre,

$S(n)$ est le vecteur des échantillons passés de $s(n)$, et

$E(n)$ est le vecteur des erreurs passées $e(n)$,

caractérisé par des moyens (12, 14, 18, 20) pour élaborer les vecteurs $A^T$ et $B^T$ par un algorithme d'adaptation faisant intervenir, dans les termes d'incrémentation :

$$e(n) \; - \; \frac{\lambda_A}{1+\lambda_A} \; s(n) \qquad \text{et} \qquad e(n) \; - \; \frac{\lambda_B}{1+\lambda_B} \; s(n)$$

où $\lambda_A$ et $\lambda_B$ sont des valeurs fixes comprises entre 0,05 et 0,3 et $e(n)$ est l'erreur de prédiction, égale à la différence entre le signal $s(n)$ et sa valeur $s(n)$ prédite.

2. Prédicteur selon la revendication 1, purement auto-régressif ayant de deux à dix coefficients, caractérisé en ce que $\lambda_A$ est proche de 0,1.

3. Prédicteur selon la revendication 1, à moyenne ajustée, caractérisé en ce que $\lambda_A$ et $\lambda_B$ sont supérieurs à 0,05 et inférieurs à 0,25.

4. Prédicteur selon la revendication 1 ou 3, caractérisé en ce que $\lambda_A$ et $\lambda_B$ ont la même valeur.

5. Prédicteur selon l'une quelconque des revendications précédentes, caractérisé en ce que lesdits moyens mettent en oeuvre l'algorithme du gradient ou du signe.

0300880

## FIG.1.

## FIG.2.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | 1978 IEEE INTERNATIONAL CONFERENCE ON ACOUSTICS, SPEECH & SIGNAL PROCESSING, Tulsa, Oklahoma, 10-12 avril 1978, pages 23-26, IEEE, US; T.W. CAIRNS et al.: "ARMA modeling applied to linear prediction of speech" * En entier * --- | 1 | H 03 H  21/00 |
| A | EP-A-0 176 312  (AMERICAN TELEPHONE AND TELEGRAPH CO.) * En entier * ----- | 1 | |

DOMAINES TECHNIQUES RECHERCHES (Int. Cl.4)

H 03 H
G 10 L

Le présent rapport a été établi pour toutes les revendications

| Lieu de la recherche | Date d'achèvement de la recherche | Examinateur |
|---|---|---|
| LA HAYE | 24-10-1988 | COPPIETERS C. |

EPO FORM 1503 03.82 (P0402)